Europäisches Patentamt

(19) European Patent Office

Office européen des brevets

(11) Publication number: **0 175 654**
**B1**

(12) **EUROPEAN PATENT SPECIFICATION**

(45) Date of publication of patent specification: **03.10.90**

(21) Application number: **85830185.6**

(22) Date of filing: **17.07.85**

(51) Int. Cl.⁵: **H 01 L 21/70, H 01 C 17/24**

(54) **Procedure for the manufacturing of double layer resistive thin film integrated resistors through ion erosion.**

(30) Priority: **20.07.84 IT 4860084**

(43) Date of publication of application:
**26.03.86 Bulletin 86/13**

(45) Publication of the grant of the patent:
**03.10.90 Bulletin 90/40**

(84) Designated Contracting States:
**DE FR GB**

(56) References cited:
**DE-A-2 757 519**
**DE-A-3 200 983**
**FR-A-2 532 472**

**NAVY TECHNICAL DISCLOSURE BULLETIN, vol.
8, no. 4, June 1983, pages 83-86, Washington,
US; H. MORRIS "A dual resistivity thin film
hybrid microcircuit"**
**PATENT ABSTRACTS OF JAPAN, vol. 5, no. 176
(E-81)848r, 12th November 1981 & JP - A - 56 101
764**

(73) Proprietor: **SELENIA INDUSTRIE
ELETTRONICHE ASSOCIATE S.p.A.
Via Tiburtina, KM 12.400
I-00131 Roma (IT)**

(72) Inventor: **Misiano, Carlo
Via G. Battista Morgagni 22
Roma (IT)**
Inventor: **Simonetti, Enrico
P. le della Radio, 14
Roma (IT)**

(74) Representative: **Gustorf, Gerhard, Dipl.-Ing.
Patentanwalt Dipl.-Ing. Gerhard Gustorf
Bachstrasse 6 A
D-8300 Landshut (DE)**

Courier Press, Leamington Spa, England.

## Description

The invention relates to a method for producing an integrated resistor having a dual resistivity thin film layer according to the preamble of claim 1.

In the article of Hayden Morris (Navy Technical Disclosure Bulletin, vol. 8, no. 7 (1983.06), pages 83 to 86) a method of employing more than one film of resistive material to form resistors of the same microcircuit substrate is disclosed, in which a substrate of glass, ceramic or the like is completely covered by a high resistivity film layer using a sputtering technique. Next, a low resistivity film layer is deposited such that is overlays the first film layer, and the low resistivity film layer is then overcoated with a metallization film layer. A plurality of conductor patterns and resistor pattern areas are delineated using photolithographic masking and etching techniques. The microcircuit substrate with the pattern areas is then annealed in a vacuum or inert atmosphere, and the low resistivity film layer is etched away in one of the resistor pattern areas. Without affecting the high resistivity film layer resulting in this film forming the resistor in this area.

DE—A 32 00 983 refers to an electrical network having a substrate with two different resistivity layers, e.g. CrSi and NiCr which are deposited by sputtering or evaporation techniques. Thin film resistors having different resistivities are realized by forming a conductive layer (Cu) on top of the said two layers; selective etching steps are performed by employing a patterned photomask to delimitate said resistors.

A similar microcircuit is known from DE—A 27 57 519 of the applicant in which on a single resistive layer of NiCr a second conductive layer of Au is deposited and then chemically etched. The etched areas are electrolitically covered by a Ni mask, and then the microcircuit substrate is completely covered by a Au layer which is also masked by a Ni pattern. Next, the Au areas not covered by the mask are etched away by an ion etching step and the masks (Ni) removed.

In order to cover a large range of values, particularly in the case of high resistances for low surface resistivity and of low resistances for high surface resistivity, single resistivity circuits are subject to three limitations:

—manufacture of very narrow resistive paths (10 to 20 μm) is inaccurate, difficult to produce and to trim and has a high rejection rate;

—the meander lines need large surfaces;

—it is impossible to realize both high and low resistances.

It is an object of the invention to provide an improved method for producing a microcircuit having at least two different surface resistivities by sequentially depositing layers of different resistive material and a conductor and subsequently etching the assembly in a sole ion erosion phase.

This object is accomplished by the invention as claimed. It is particularly applicable in the field of hybrid circuits and microwave integrated circuits.

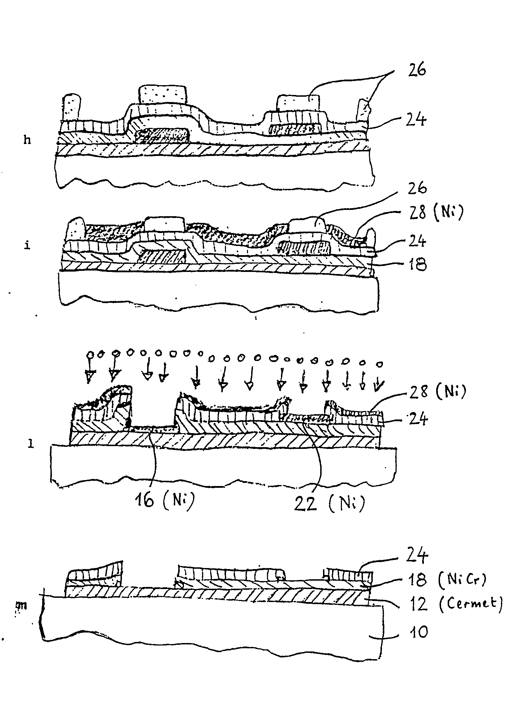

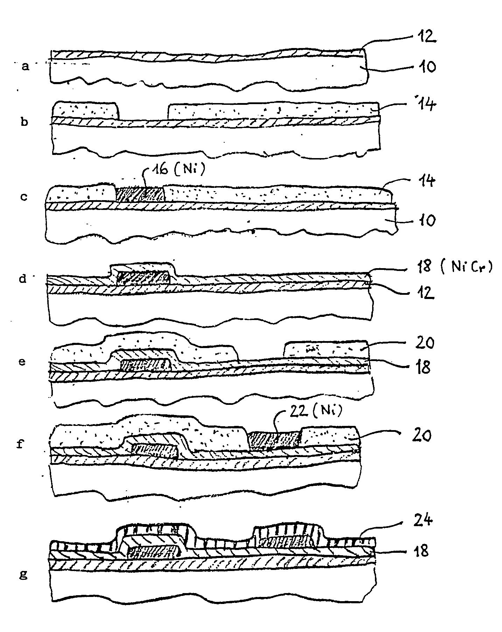

Further advantages of the invention will become apparent from the following description of a preferred example with reference to the drawing which illustrates the manufacture steps for producing an integrated microcircuit having a low and a high resistive layer.

As illustrated in part a, a substrate 10 of alumina ($Al_2O_3$) is coated by RF sputtering with a high resistivity film layer 12 of cermet. In the following step b, said cermet layer 12 is photomasked by a photopolymer 14, e.g. AZ 1350 H. In c is illustrated the electrolytic growth of the mask 16 of Ni having a thickness of about 2 μm; the photopolymer 14 is then removed.

Next (step d), a low resistivity film layer 18 of NiCr is deposited by a RF sputtering technique, which is then—step e—photomasked by a photopolymer 20 (AZ 1350 H). Similar to step c, in the following step f is illustrated the electrolytic growth of the mask 22 of Ni having a thickness of about 2 μm; the photopolymer 20 is then removed.

In step g, an antidiffusive conductive triple layer 24 is deposited, e.g. NiCr—Pt—Au, which is subsequently (step h) photomasked by patterns 26. Again (step i) we have an electrolytic growth of a mask 28 of Ni having a thickness of about 3 μm; the photopolymer patterns 26 are then removed.

In step 1, the areas not covered by the masks are etched by an ion attack technique. Finally, the residual Ni masks 16, 22 and 26 are removed (step m).

According to the invention it is possible to obtain, with a single etching step, at least two different resistivity areas on a substrate.

## Claim

Method for producing a multi resistivity thin film microcircuit having a substrate (10) which is covered by at least two layers (12, 18) of different resistive material and a conductive layer (24), characterized in that the different resistive layers (12, 18) are directly provided in the desired resistor areas with a mask (16, 22) which is electrolytically grown in the openings of photopolymer layers (14, 20), which are in turn removed, in that the covering conductive layer (24) is also masked by a photopolymer in which a pattern (26) is provided for the electrolytic growth of a further mask (28), after which said photopolymer layer (26) is removed, and in that the areas not covered by the residual masks (16, 22, 28) are etched away in a single step by ion attack before removing said residual masks.

## Patentanspruch

Verfahren zum Herstellen einer mehrere spezifische Widerstände aufweisenden Dünnschicht-Mikroschaltung mit einem Substrat (10), das von mindestens zwei Schichten (12, 18) aus unterschiedlichem Widerstandsmaterial und einer leitenden Schicht (24) bedeckt ist, dadurch gekennzeichnet, daß die unterschiedlichen Widerstandsschichten (12, 18) direkt in den gewünschten Widerstandsbereichen mit einer Maske (16, 22) gebildet werden, die elektrolytisch durch Wachstum in den Öffnungen von Photopolymerschichten (14, 20) gebildet wird, welche ihrerseits entfernt werden, daß die abdeckende leitende Schicht (24) ebenfalls durch ein Photopolymer maskiert wird, in welchem für das elektrolytische Wachstum einer weiteren Maske (28) ein Muster (26) vorgesehen ist, woraufhin die Photopolymerschicht (26) beseitigt wird, und daß die nicht von den Rest-Photomasken (16, 22, 28) bedeckten Bereiche in einem einzigen Schritt durch Ionenerosion fortgeätzt werden, bevor die Rest-Masken entfernt werden.

**Revendication**

Procédé pour produire un microcircuit ou microstructure à couche mince de résistivités multiples comportant un substrat ou support (10) recouvert d'au moins deux couches (12, 18) de substances de résistivités différentes et une couche conductrice (24), caractérisé en ce que les couches résistives différentes (12, 18) sont directement pourvues, dans les différentes zones de résistance, d'un masque (16, 22) qui est formé par croissance électrolytique dans les ouvertures des couches d'un photopolymère (14, 20) qui sont, à leur tour, enlevées, en ce que la couche conductrice de couverture (24) est également masquée au moyen d'un photopolymère comportant un tracé (26) pour permettre la croissance électrolytique d'un deuxième masque (28), en ce qu'ensuite, on enlève ladite couche photopolymère (26) et en ce que les zones non couvertes par les masques résiduels (16, 22, 28) sont enlevées par gravure en une seule étape au moyen d'une technique d'érosion ionique avant d'enlever lesdits masques résiduels.

h

26

24

i

26
28 (Ni)
24
18

l

28 (Ni)
24

16 (Ni)        22 (Ni)

m

24
18 (NiCr)
12 (Cermet)
10